# EUROPEAN PATENT APPLICATION

(11) **EP 2 373 146 A2**
(43) Date of publication of application: **05.10.2011**
(21) Application number: 11154779.0
(22) Date of filing: 17.02.2011
(51) Int. Cl.: H05K 13/04

(54) **Method of removing part having electrode on the bottom**

(30) Priority: 31.03.2010 JP 2010083782
(71) Applicant: Fujitsu Limited, Kawasaki-shi, Kanagawa 211-8588 (JP)
(72) Inventor: Takada, Rie, Kanagawa 211-8588 (JP); Yamamoto, Tsuyoshi, Kanagawa 211-8588 (JP)
(74) Representative: Lewin, David Nicholas

(57) **Abstract**

In the initial state, a part(21) having a bottom electrode(31) such as a BGA is attached to a substrate(10). A heat transfer material(41) such as low melting point solder is allowed to fill a gap between the substrate(10) and the part(21) having the bottom electrode(31), and the heat transfer material(41) and the BGA serving as the bottom electrode(31) are heated. The heat transfer material(41) and the BGA are melted by the heating so that the part(21) having the bottom electrode(31) is removed from the substrate(10).

## Description

### FIELD

Embodiments discussed herein are related to a method of removing a part having electrodes on the bottom.

### BACKGROUND

In recent years, bottom electrodes such as a Ball Grid Array (BGA) have been widely used for electronic parts as the electronic parts are highly integrated and come to incorporate high functions therein. In addition, a technology is known which improves the reliability of operation of the electronic part by filling a gap between the electronic part and a substrate with a resin or the like to fix the electronic part by bonding to the substrate.

Further, since a server or a backbone device is expensive, there is a demand on that in the part having electrodes on the bottom, such as a BGA and a power supply module, the unit of the part is analyzed and then reused instead of disposal when version-up is needed, a defectiveness of the part is found, a mounting error occurs, or the like.

For this reason, some operations of removing the part from the server or the backbone device and attaching a new part need to be performed.

In a part having electrodes on the bottom, the connection portion may not melt under direct heating using a soldering iron. Therefore, the part was removed from or attached to the substrate in such a manner that the entirety of the part or the substrate was heated by a thermal wind type rework device so that a heat in an amount that corresponds to or more than a melting point of solder was applied to the bonding portion of the bottom surface of the part to cause the bonding portion to melt. In order to cause the bonding portion to melt, SnPb-based solder needs to be heated to 190°C or more and SAC-based solder needs to be heated to 225°C or more. Examples of the related arts include Japanese Laid-open Patent Publication No. 10-163270, Japanese Laid-open Patent Publication No. 2003-246828, Japanese Laid-open Patent Publication No. 11-168156, and Japanese Laid-open Patent Publication No. 2006-019452.

In the electronic part, a tolerance number, the permitted number of instances of heating of the electronic part at a predetermined temperature or higher, is set as a heat resistance number in order to ensure operation of the electronic part. For example, when the heat resistance number of an electronic part is two, in the related art, the first thermal damage occurs at the time of the initial attachment of the electronic part and the second thermal damage occurs at the time of the removal of the electronic part. When the removed part is reattached to the substrate, the third thermal damage occurs, which exceeds the thermal resistance number.

Further, when the electronic part having electrodes on the bottom is mounted on the substrate and the part is attached to or removed from the substrate by the thermal wind type rework device, there is a concern in that neighboring parts may be thermally affected when a gap between the target electronic part and the neighboring electronic part is narrow. When the gap between the parts is widened in order to prevent the neighboring electronic part from being thermally damaged, high density mounting may be impeded.

In particular, the lead-free of the bonding portion has been demanded. Further, in the BGA, eutectic having a melting point of about 190°C is replaced with SAC having a melting point of about 225°C, and hence the melting point of the solder is increased by about 35°C. In the past, the gap between the parts was designed so as to prevent the neighboring parts from being thermally damaged on the assumption that the electronic part was mounted or removed by the heating of about 190°C. However, the temperature of the thermal wind used when mounting or removing the electronic part becomes higher as the melting point of the solder becomes higher. Further, the neighboring part becomes more thermally affected as the heating time becomes longer. When the design of the arrangement of the parts within the substrate is changed in accordance with the replacement to the SAC, there is a problem in that the manufacturing cost increases due to the redesign or the mounting density of the parts decreases.

Accordingly, it is an object in one aspect of an embodiment of the invention to provide a method of removing a part having electrodes on the bottom, suppressing the part from being thermally damaged when the part is removed from a substrate.

### SUMMARY

According to an aspect of an embodiment of the invention, a method of removing a part having a bottom electrode includes filling a gap between a substrate and the part soldered to the substrate through the bottom electrode, with a heat transfer material; heating the heat transfer material and the bottom electrode; and removing the part from the substrate.

### BRIEF DESCRIPTION OF DRAWINGS

FIG. 1 is an explanatory diagram illustrating a method of removing a bottom electrode-type part according to one embodiment;
FIG. 2 is an explanatory diagram illustrating a heating operation using nichrome wires illustrated in FIG. 1;
FIG. 3 is an explanatory diagram illustrating comparative examples of removing and mounting operations of the bottom electrode part using a reflow device;
FIG. 4 is an explanatory diagram illustrating a comparative example of a removing operation of a small electronic part;
FIG. 5 is an explanatory diagram illustrating a comparative example of a remounting operation of a small electronic part;
FIG. 6 is an explanatory diagram illustrating a removing operation of the bottom electrode part using reflow according to the embodiment;
FIG. 7 is an explanatory diagram illustrating a filling operation of a heat transfer material;
FIG. 8 is a (first) explanatory diagram illustrating a removing operation of the bottom electrode part from a substrate having a through hole;
FIG. 9 is a (second) explanatory diagram illustrating a removing operation of the bottom electrode part from the substrate having the through hole;
FIG. 10 is a (third) explanatory diagram illustrating a removing operation of the bottom electrode part from the substrate having the through hole;
FIG. 11 is an explanatory diagram illustrating a mixture between a BGA and a heat transfer material; and
FIG. 12 is an explanatory diagram illustrating a melting point of mixed solder.

### DESCRIPTION OF EMBODIMENT

Hereinafter, embodiments of the present invention will be explained with reference to accompanying drawings. Further, the invention is not limited to the detailed embodiment below.

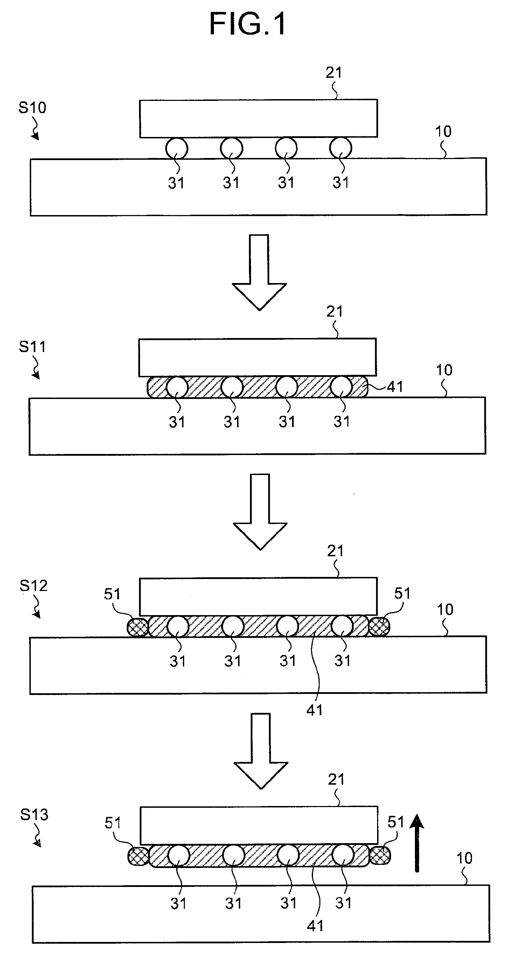

FIG. 1 is an explanatory diagram illustrating a method of removing a part having electrodes on the bottom according to one embodiment. As illustrated in FIG. 1, a bottom electrode part (a part having electrodes on the bottom) 21 having a BGA 31 is attached to a substrate 10 in initial step S10.

In the method of removing a part having electrodes on the bottom according to the embodiment, a heat transfer material 41 fills a gap between the bottom electrode part 21 and the substrate 10 in step S11. Then, the heat transfer material 41 and the BGA 31 serving as bottom electrodes are heated in step S12. The heat transfer material 41 and the BGA 31 are melted by the heating so that the bottom electrode part 21 is removed from the substrate 10 in step S13.

Low melting point solder may be used as the heat transfer material 41, where the low melting point solder has a melting point lower than that of the BGA 31. Further, in the step of heating the heat transfer material 41 and the BGA 31, for example, nichrome wires 51 serving as heating members are brought into contact with an integrated area of the heat transfer material 41 and the BGA 31 so that the area is heated through heat transfer.

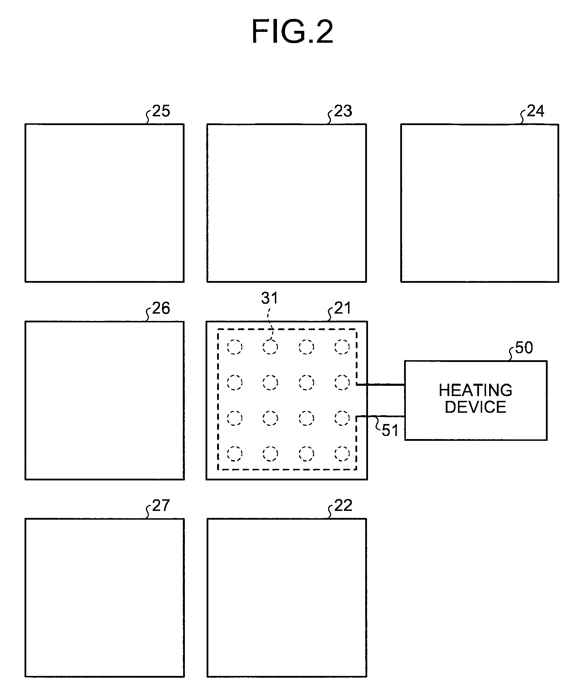

FIG. 2 is an explanatory diagram illustrating a heating operation using the nichrome wires 51. In the example illustrated in the drawing, bottom electrode parts 21 to 27 are disposed on the substrate. The bottom electrode parts 22, 23, and 26 are adjacent to the bottom electrode part 21 at three sides thereof among four sides of the bottom electrode part 21. One side of the bottom electrode part 21 has an extra mounting area. A heating device 50 heating the nichrome wires 51 is disposed on the remaining side having the extra mounting area, and the area formed by integrating the heat transfer material 41 with the BGA 31 is surrounded and heated by the nichrome wires 51, so that the bottom electrode part 21 is heated.

By performing the heating through the heat transfer of the nichrome wires 51, the bottom electrode part 21 may be removed without thermal damage to the bottom electrode parts 22, 23, and 26 even when the gap between the bottom electrode part 21 and each of the bottom electrode parts 22, 23, and 26 is from 1 to 3 mm or so. Further, since the electrode portion is locally heated, thermal damage to the bottom electrode part 21 may be suppressed.

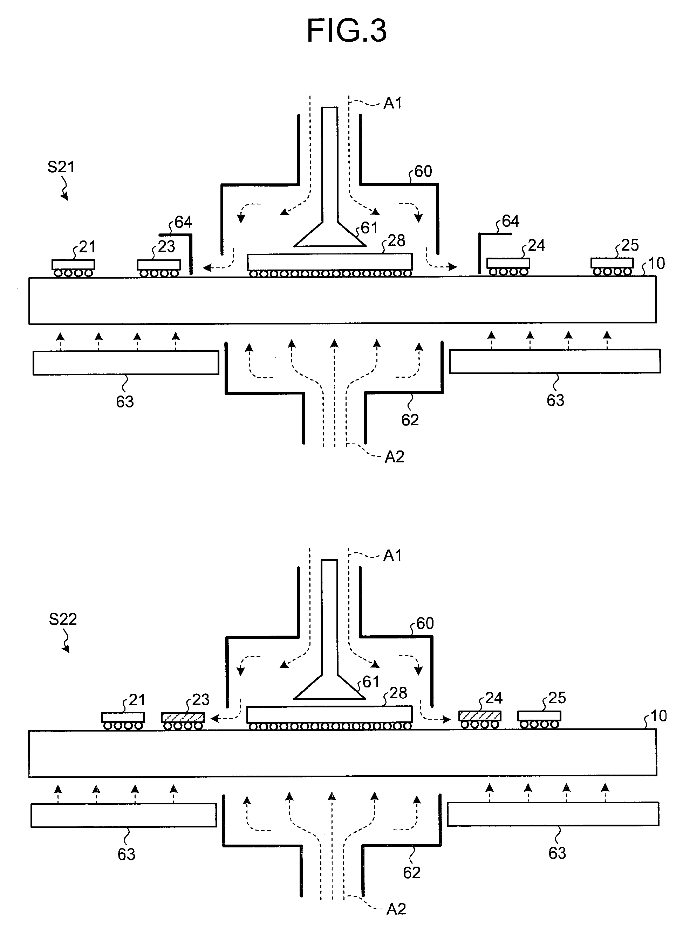

FIG. 3 is an explanatory diagram illustrating the comparative examples of the removing and mounting operations of the bottom electrode part using a reflow device. In the examples illustrated in FIG. 3, both large and small bottom electrode parts are designed to have a gap in consideration of a thermal influence between adjacent parts at the time of a rework, and the thermal resistance number of each bottom electrode part is set to two. As for the assurance of the general electronic part, the thermal resistance is 150°C or less, and the thermal resistance number (thermal count) of 150°C or more is two or less.

In step S21 illustrated in FIG. 3, an arm portion 61 contacts a large bottom electrode part 28 while the large bottom electrode part 28 is covered by a reflow device 60, and hot wind is blown to the bottom electrode part 28 so as to melt the BGA. In order to heat and melt the bonding portion of the BGA up to 230°C, a reflow device 62 is additionally disposed on the opposite side of the substrate 10 in addition to the reflow device 60, and the entire substrate 10 is heated by a heating plate 63. At this time, the temperatures of the hot winds A1 and A2 blown from the reflow devices 60 and 62 are substantially equal to 300°C.

In the configuration illustrated in step S21, a gap of 10 mm or more is provided between the bottom electrode part 28 and each of the adjacent bottom electrode parts 23 and 24. When a windshield member 64 blocking the hot wind blown from the reflow device 60 is disposed in the gap, the bottom electrode parts 23 and 24 may be prevented from being affected by the heat used to remove the bottom electrode part 28.

However, in the design in which the gap between the parts is set to be large and the windshield member 64 is disposed in the gap, the mounting density is degraded. Further, since the thermal wind corresponding to or exceeding the thermal resistance of the part is applied to the bottom electrode part 28, there is a possibility that the failure analysis or the like may be difficult due to the breakage of the bottom electrode part 28.

In the configuration illustrated in step S22, the gap between the bottom electrode part 28 and each of the bottom electrode parts 23 and 24 is set to be small, and the mounting density is improved. In the configuration illustrated in step S22, thermal damage occurs in the bottom electrode parts 23 and 24 when the bottom electrode part 28 is removed. Since the thermal damage occurs once in the bottom electrode parts 23 and 24 at the time of the attachment of the bottom electrode parts 23 and 24, the number of instances that the thermal damage occurs in the bottom electrode parts 23 and 24 become two when the bottom electrode part 28 is removed from the substrate. Accordingly, when a new bottom electrode part is attached to the substrate after removal of the bottom electrode part 28, the total number of instances that the thermal damage occurs in the bottom electrode parts 23 and 24 becomes three, and thus there is a possibility that the bottom electrode parts 23 and 24 are broken.

The large electronic part such as the bottom electrode part 28 is heated alone by the reflow device. However, in the case of the small electronic part, plural electronic parts may be simultaneously heated by the reflow device.

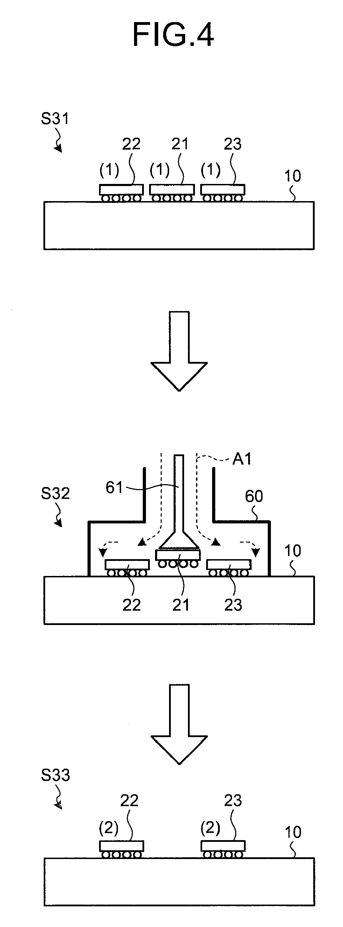

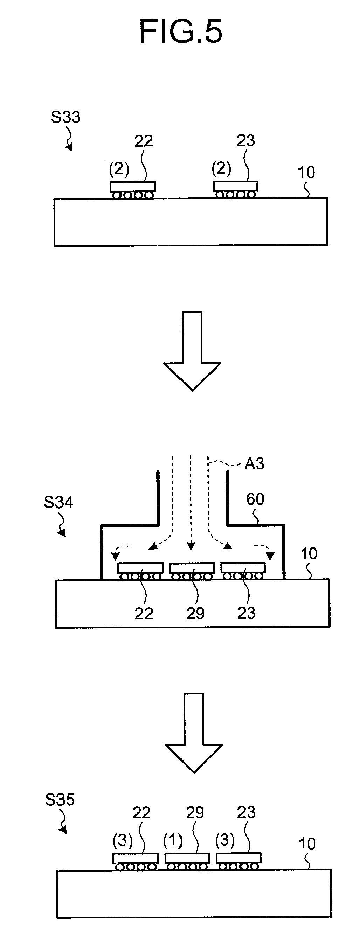

FIGS. 4 and 5 are explanatory diagrams illustrating the comparative examples of the removing and mounting operations of a small electronic part. Further, in FIGS. 4 and 5, the reflow device 62 or the heating plate 63 is not illustrated and the description thereof is not repeated. In step S31 illustrated in FIG. 4, the small bottom electrode parts 21 to 23 are mounted on the substrate 10 in an order of the bottom electrode part 22, the bottom electrode part 21, and the bottom electrode part 23. The thermal damage occurs once in the bottom electrode parts 21 to 23 at the time of the mounting operation.

When the bottom electrode part 21 is removed, the arm portion 61 contacts the bottom electrode part 21 while the bottom electrode parts 21 to 23 are covered by the reflow device 60, and the BGA 31 is melted by the thermal wind A1 so as to remove the bottom electrode part 21 in step S32.

As a result, the bottom electrode part 21 is removed as illustrated in step S33, and the number of instances that the thermal damage occurs in the bottom electrode parts 22 and 23 becomes two.

As illustrated in FIG. 5, a new bottom electrode part 29 is loaded between the bottom electrode parts 22 and 23, and the BGA is heated and melted by the thermal wind A3 while the bottom electrode parts 22, 23, and 29 are covered by the reflow device 60 and thus the bottom electrode part 29 is mounted on the substrate in step S34. As a result, as illustrated in step S35, the total number of instances that the thermal damage occurs in the bottom electrode parts 22 and 23 becomes three, and thus there is a possibility that the bottom electrode parts are broken.

Likewise, in the bottom electrode part removal method illustrated as the comparative example, the thermal damage to neighboring parts occurs once more. The thermal resistance number of general parts with respect to the reflow is two. Since one time of thermal damage is counted due to the reflow at the time of the assembly, the remaining thermal resistance number is one. When the second thermal damage is applied to the neighboring part due to the rework (removal) as in the comparative example, the third thermal damage occurs at the time of the next component mounting operation. When a gap of 10 mm or more is ensured between the parts in order to avoid the occurrence of the thermal damage, the high density of the components is degraded.

Further, the gap between the BGA parts of the eutectic balls is designed to be 10 mm at minimum. However, when the eutectic is replaced with the SAC for the purpose of lead-free, the design is changed so that the gap is increased since the occurrence of the thermal damage on the neighboring parts may not be avoided in the design for the eutectic.

Then, in connection with the removed part, if the thermal damage occurs at the time of removal, it results to be subjected to the thermal damage twice, that is, at the time of mounting and at the time of removing and thus it is broken. Therefore, the removed part may not be analyzed and reused.

As an example, the thermal resistance of the BGA may be assured in a range of from 240°C to 260°C or so. When thermal wind of 300°C or more is blown to the top portion of the BGA in order to remove the BGA bonding portion at 230°C as the melt temperature thereof by using a reflow device, the temperature of the part in the BGA becomes 260°C or more so that the part in the BGA is broken.

On the contrary to the comparative examples, in the method disclosed in the embodiment, low melt solder, for example, solder powder, solder paste, or melted solder is injected into a gap of a bonding portion of the bottom electrode part of a removal target so that balls of the BGA are short-circuited, and the periphery of the bonding portion is surrounded by a heating element. When the bonding portion is directly heated, the bottom electrode part may be removed without thermal influence on adjacent parts.

In addition, when the bonding portion is directly heated, an increase in temperature of internal elements of the bottom electrode part is suppressed and thus the breakage of the internal elements may be prevented. That is, in the method disclosed herein, the occurrence of the thermal damage not only to the target part, but the neighboring parts may be avoided. Further, the gap between the parts may be realized in a range from 1 to 3 mm or so. For this reason, the improvement in mounting density may be realized, and the lead-free may be realized by using SAC as solder in the existing design.

Further, since the solder is mixed with the bonding portion of the BGA 31 by using the low melting point solder having a melting point lower than that of the BGA 31 as the heat transfer material 41, the heating temperature at the time of the removal may be decreased.

A variation in melting point caused by the mixture of the solder will be described. The movement of atoms becomes easier in accordance with an increase in temperature, and a diffusion phenomenon occurs. The speed and the amount of the diffusion are dependent on the temperature and the time. When different types of metals physically contact each other, a mutual diffusion phenomenon occurs in which different types of metal atoms move toward each other. The diffusion phenomenon also occurs even when the metal is in a solid state. This is called solid-phase diffusion.

Then, when the temperature of the metal reaches the melting point of one of metals so that the metal becomes a liquid state, liquid-phase diffusion occurs in which the speed of the diffusion is faster than that of the solid-phase diffusion. When the liquid-phase diffusion occurs in the contact portion between the metals, the atoms thereof are mixed with each other, and the state in which the metal is melted at the melting point in the composition of alloy rapidly spreads. As a result, even the metal having a high melting point becomes a liquid state at the lower temperature, and hence the metals are integrated with each other in a melted state substantially at the low melting point.

Accordingly, when the bonding portion is heated by using the low melting point solder, having a melting point lower than that of the BGA 31, as the heat transfer material 41, the bottom electrode part 21 may be removed at a melting point of the alloy of the BGA 31 and the heat transfer material 41, where the melting point of the alloy is lower than that of the BGA 31.

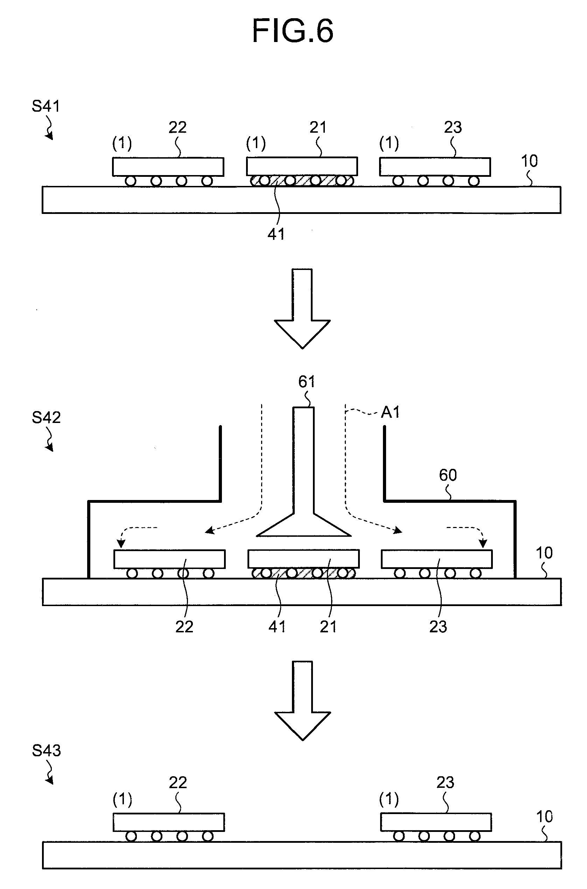

Therefore, as described above, the heating method is not limited to the heat transfer using the nichrome wires 51 or the like, and the occurrence of the thermal damage at the time of the removing operation of the bottom electrode part may be suppressed even when the reflow is used. FIG. 6 is an explanatory diagram illustrating an operation of removing the bottom electrode part through the reflow according to the embodiment.

In the example of FIG. 6, a case will be described in which the bottom electrode part 21 is removed while the bottom electrode parts 21 to 23 are mounted on the substrate 10 in an order of the bottom electrode part 22, the bottom electrode part 21, and the bottom electrode part 23.

First, the heat transfer material 41 comes to fill a gap between the substrate 10 and the bottom electrode part 21 serving as a removal target in step S41. Then, the arm portion 61 contacts the bottom electrode part 21 while the bottom electrode parts 21 to 23 are covered by the reflow device 60, and the BGA 31 and the heat transfer material 41 are heated and melted by the hot wind A1 so as to remove the bottom electrode part 21 in step S42.

The removal heating temperature may be set to a temperature at which the bottom electrode parts 21 to 23 are not thermally damaged due to the reason that the melting point of the BGA 31 is decreased by the mixture with the heat transfer material 41. For this reason, the number of instances that the thermal damage occurs in the bottom electrode parts 22 and 23 is one after the bottom electrode part 21 is removed in step S43. Further, the number of instances that the thermal damage occurs even in the removed bottom electrode part 21 is one. Accordingly, even when a new part is mounted between the bottom electrode parts 22 and 23, the operation of the bottom electrode parts 22 and 23 may be assured. In the same way, even the removed bottom electrode part 21 may be analyzed and reused.

Further, the heating using the heat transfer of the nichrome wires 51 or the like, the heating using the thermal wind of the reflow devices 60 and 62, and the heating using the heating plate 63 may be used in combination. For example, the entire unit is heated at the part assurance temperature, for example, 150°C or less by the reflow devices 60 and 62 and the heating plate 63. Accordingly, the low melting point solder injected to the gap between the bottom electrode part 21 and the substrate 10 is melted, and the entire BGA bonding portion is integrated.

Then, the bonding portion integrated by the low melting point solder is further directly heated by the nichrome wires 51. At this time, the nichrome wires 51 are heated up to, for example, about 200°C. By the heating, the temperature of the low melting point solder is increased, and the solder balls of the BGA 31 are melted.

When the entire area of the bonding portion is melted due to the melting of the solder balls of the BGA 31 the bottom electrode part 21 may be removed. Further, the melting point obtained by mixing the low melting point solder with the solder ball of the BGA 31 is about 155°C when using SnIn as the low melting point solder, and is about 170°C when using SnBi as the low melting point solder.

After the bottom electrode part 21 is removed, the solder remaining in the bonding portion is removed and the bonding portion is cleaned. Afterwards, a new electronic part may be mounted by the general rework method.

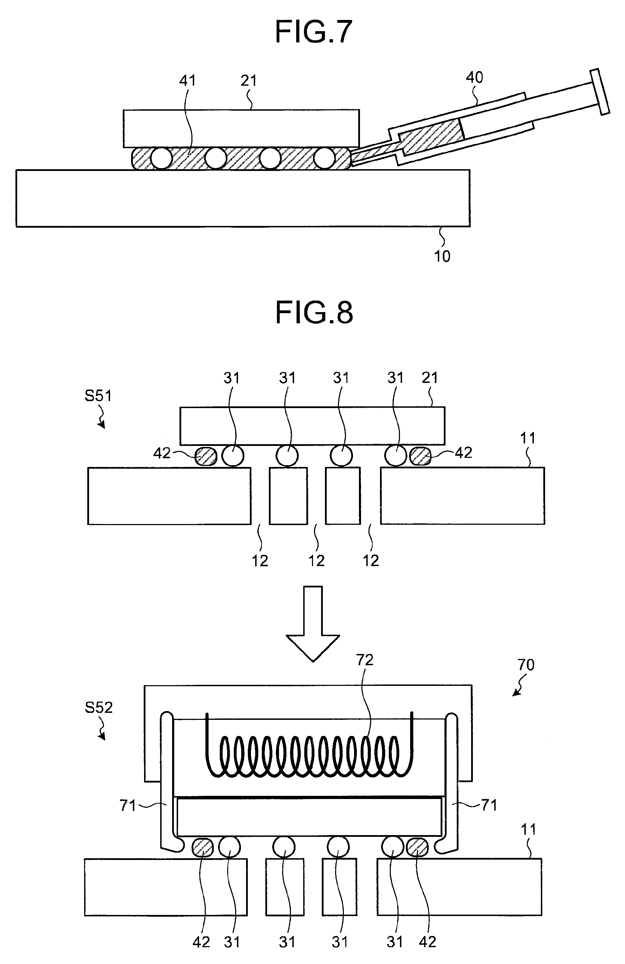

FIG. 7 is an explanatory diagram illustrating a filling operation of the heat transfer material 41. Regarding the heat transfer material 41, for example, the low melting point solder may be injected in a paste state by an injector 40 as illustrated in FIG. 7. Further, when the substrate has a penetration hole, that is, a through hole, the heat transfer material 41 may be injected via the through hole.

FIGS. 8, 9, and 10 are explanatory diagrams illustrating a removing operation of the bottom electrode part from the substrate with the through hole. First, a substrate 11 having the bottom electrode part 21 mounted thereon has through holes 12 that are formed between the lands of the BGA 31 as illustrated in S51 of FIG. 8.

A string-like solder 42 is wound around the bonding portion of the BGA 31 of the bottom electrode part 21, and blocks the gap between the substrate 11 and the BGA 31 so as to prevent the leakage of solder powder 43 to be described later in step S51. It is desirable that the melting point of the string-like solder 42 is equal to or lower than the melting point of the BGA 31, for example, the low melting point solder such as indium solder having a melting point of about 150°C.

Subsequently, a heating jig 70 having claw portions 71 formed on two or four sides thereof and a heater 72 built therein comes into close contact with the upper portion of the bottom electrode part 21, and the claw portions 71 hook the bonding portion of the bottom electrode part 21 while being disposed in the gap of the bonding portion so as to press and fix the string-like solder 42 in step S52. Further, the heating jig 70 may have, for example, a ceramic heater or the like.

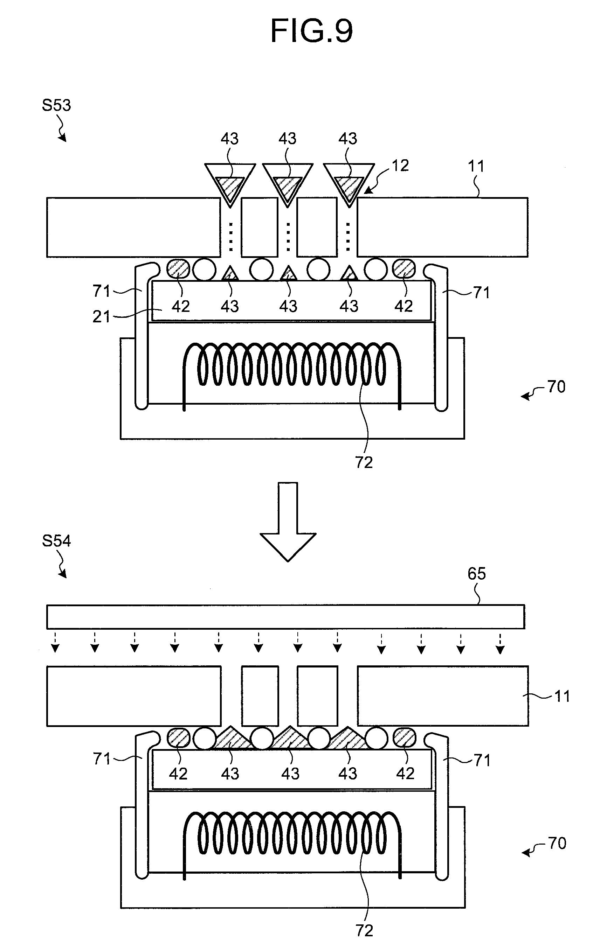

Then, the substrate 11 is disposed so that the lower side of the bottom electrode part 21 of FIG. 9 faces the gravity direction, and the solder powder 43 is injected into the BGA 31 via the through holes 12 in step S53. The solder powder 43 may be injected by using, for example, an infundibulum-shaped tool. Further, it is desirable that even the solder powder 43 is the low melting point solder having a melting point of 150°C or less as in the string-like solder 42.

Subsequently, the substrate 11 is heated by a heating plate 65 disposed on the opposite side of the bottom electrode part 21 at the temperature in which the thermal resistance of the part or the substrate may be assured without any problem, for example, about 150°C, and the claw portions 71 of the heating jig 70 are heated to the melting point or more of the BGA 31, for example, 225°C or more (S54).

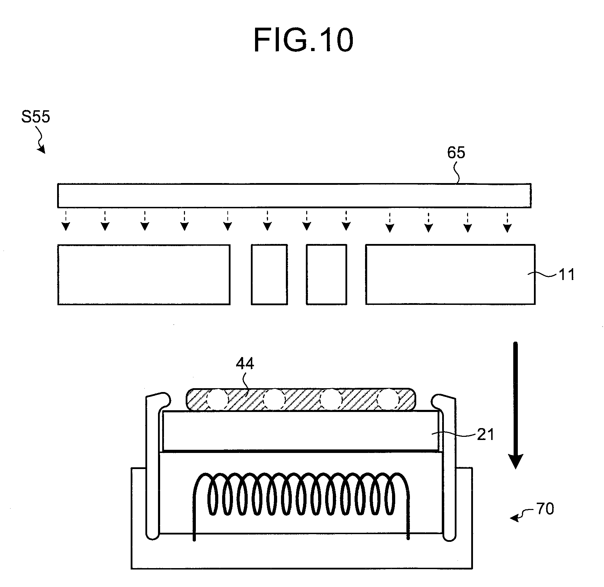

By the heating, as illustrated in FIG. 10, the low melting point solder (the string-like solder 42 and the solder powder 43) filled in the bonding portion of the BGA 31 is melted at about 150°C, and the balls of the BGA 31 are connected to each other. Since the solder and the balls are integrated with each other, the BGA 31 may be uniformly and efficiently heated. Then, when the BGA 31 reaches the melting point, the BGA 31 and the low melting point solder are changed to a mixed solder 44, and the bottom electrode part 21 is dropped by the own weight of the heating jig 70 in step S55. For this reason, the bottom electrode part 21 may be removed without thermally affecting the neighboring parts or the substrate.

Further, a case has been described herein in which the bottom electrode part 21 is removed by the gravity. However, for example, an elastic body or the like may be provided in the heating jig 70, and a force may be applied to the bottom electrode part 21 in a direction in which the bottom electrode part is removed from the substrate 11.

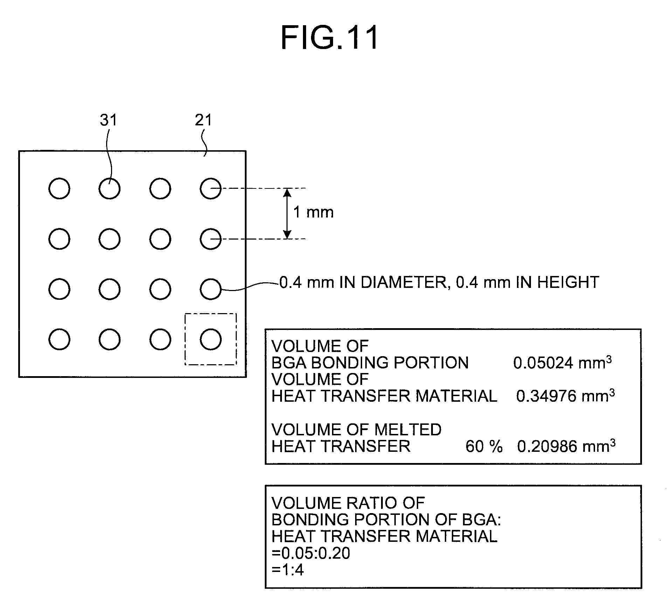

FIG. 11 is an explanatory diagram illustrating a mixture between the BGA and the heat transfer material. In the example illustrated in FIG. 11, the diameter and the height of the ball of the BGA 31 of the bottom electrode part 21 are 0.4 mm, and the pitch of the ball of the BGA 31 is 1 mm. In this case, the volume of the bonding portion of the BGA 31 is 0.05024 mm³, and the volume of the heat transfer material 41 is 0.34976 mm³. The volume of the melted heat transfer material 41 is 0.20986 mm³ which is 60% of 0.34976 mm³. Accordingly, the ratio of the volume after the melting thereof is as below.
Bonding portion of BGA 31 : Heat transfer material 41
= 0.05 : 0.20
= 1 : 4

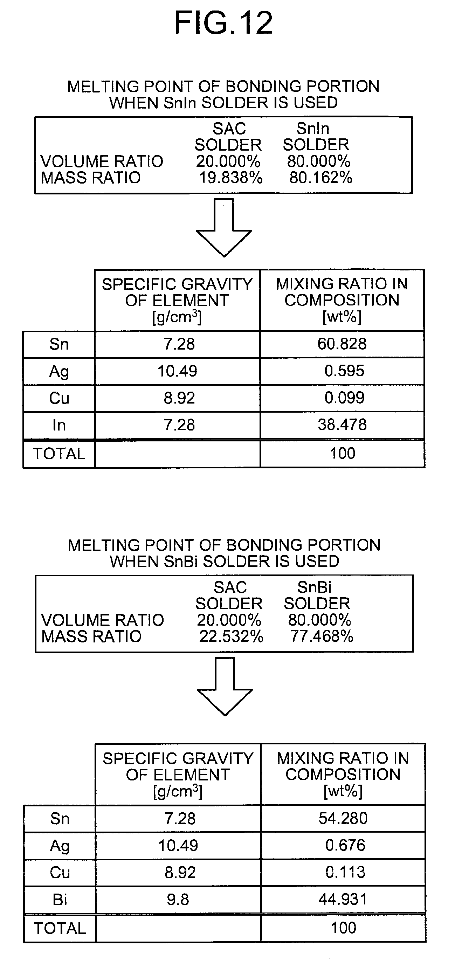

FIG. 12 is an explanatory diagram illustrating a melting point of the mixed solder. When SAC solder is used as the BGA 31 and SnIn is used as the heat transfer material 41, the volume ratio is obtained such that SAC is 20.000% and SnIn is 80.000%, and the mass ratio is obtained such that SAC is 19.838% and SnIn is 80.162%.

Regarding the element mass density [g/cm³] and the mixing composition ratio [wt%], the element mass density [g/cm³] and the mixing composition ratio [wt%] of tin (Sn) are 7.28 g/cm³ and 60.828 wt%, and the element mass density [g/cm³] and the mixing composition ratio [wt%] of silver (Ag) are 10.49 g/cm³ and 0.595 wt%. Then, the element mass density [g/cm³] and the mixing composition ratio [wt%] of copper (Cu) are 8.92 g/cm³ and 0.099 wt%, and the element mass density [g/cm³] and the mixing composition ratio [wt%] of indium (In) are 7.28 g/cm³ and 38.478 wt%. Since the eutectic melting point of Sn-48In is 117°C, the liquid-phase temperature assumed from the Sn-In two-dimensional phase diagram is 155°C.

When SAC solder is used as the BGA 31 and SnBi is used as the heat transfer material 41, the volume ratio is obtained such that SAC is 20.000% and SnBi is 80.000%, and the mass ratio is obtained such that SAC is 22.532% and SnBi is 77.468%.

Regarding the element mass density [g/cm³] and the mixing composition ratio [wt%], the element mass density [g/cm³] and the mixing composition ratio [wt%] of tin (Sn) are 7.28 g/cm³ and 54.280 wt%, and the element mass density [g/cm³] and the mixing composition ratio [wt%] of silver (Ag) are 10.49 g/cm³ and 0.676 wt%. Then, the element mass density [g/cm³] and the mixing composition ratio [wt%] of copper (Cu) are 8.92 g/cm³ and 0.113 wt%, and the element mass density [g/cm³] and the mixing composition ratio [wt%] of bismuth (Bi) are 9.8 g/cm³ and 44.931 wt%. Since the eutectic melting point of Sn-58Bi is 139°C, the liquid-phase temperature assumed from the Sn-Bi two-dimensional phase diagram is 170°C.

As described above, the method of removing a part having electrodes on the bottom according to the embodiment is conducted in such a manner that the gap between the substrate and the bottom electrode part soldered to the substrate is filled with the heat transfer material through the bottom electrode, and the heat transfer material and the bottom electrode are integrated with each other and heated so as to be removed from the substrate.

For this reason, the removal target part may be removed without the thermal damage occurring in the removal target part or the neighboring parts, and the part may be replaced, reused, and analyzed. Further, since the mounting density of the part is improved, the design may not be changed due to the lead-free.

Further, the embodiment is merely an example, and the type or the shape of the part having electrodes on the bottom, the material or the shape of the electrode, the material of the heat transfer material, the heating method, and the like may be appropriately modified.

The method of removing a part having electrodes on the bottom disclosed in the invention has an advantage of providing a method capable of removing a part having electrodes on the bottom, suppressing the thermal damage to the electronic part.

## Claims

1. A method of removing a part(21) having a bottom electrode(31), the method comprising:
filling a gap between a substrate(10) and the part(21) soldered to the substrate (10) through the bottom electrode(31), with a heat transfer material(41);
heating the heat transfer material(41) and the bottom electrode(31); and
removing the part(21) from the substrate(10).

2. The method of removing a part(21) having a bottom electrode(31) of claim 1,
wherein the heat transfer material(41) is formed of solder material having a lower melting point than the bottom electrode(31).

3. The method of removing a part(21) having a bottom electrode (31) of claim 1 or 2,
wherein said heating is conducted using a heating member(51) that heats an area at which the heat transfer material(41) and the bottom electrode(31) are integrated, by heat transfer while it is in contact with the area.

4. The method of removing a part(21) having a bottom electrode(31) of claim 3,
wherein the heating member(70) includes a claw portion (71) configured to hold the part(21).

5. The method of removing a part(21) having a bottom electrode(31) of claim 4,
wherein the area is heated by the claw portion (71) by heat transfer.

6. The method of removing a part(21) having a bottom electrode(31) of any of claims 1 to 5,
wherein a force is applied to the part(21) in a direction in which the part(21) is removed from the substrate(11).

7. The method of removing a part(21) having a bottom electrode(31) of any one of claims 1 to 6,
wherein the substrate(11) is provided with a through-hole(12), and
the heat transfer material(42) is filled into the gap through the through-hole(12).
